# EUROPÄISCHE PATENTANMELDUNG

(11) **EP 2 528 090 A1**
(43) Veröffentlichungstag der Anmeldung: **28.11.2012**
(21) Anmeldenummer: 11004149.8
(22) Anmeldetag: 19.05.2011
(51) Int. Cl.: H01L 23/31, H01L 21/56, H01L 21/329, H01L 21/683, H01L 25/07, H01L 29/06, H01L 29/786

(54) **Halbleiter-Bauelement und Verfahren zu dessen Herstellung**

(71) Anmelder: ACST Advanced Compound Semiconductor Technologies GmbH, 64283 Darmstadt (DE)
(72) Erfinder: Cojocari, Oleg, 63454 Hanau (DE)
(74) Vertreter: Schmidt, Oliver

(57) **Zusammenfassung**

Die Erfindung betrifft die Herstellung von Halbleiter-Bauelementen für sehr hohe Frequenzen. Dazu wird eine Halbleiter-Schaltung mit zumindest einem Halbleiter-Schaltungselement bereitgestellt, wobei das Halbleiter-Schaltungselement
- funktionelle epitaktische Halbleiterschichten (4, 6) umfasst, und wobei die Halbleiter-Schaltung
- eine Kunststoffschicht (23) umfasst, welche das Halbleiter-Schaltungselement abdeckt und einbettet und einen freitragenden Träger für das Halbleiter-Schaltungselement bildet.

## Beschreibung

Die Erfindung betrifft allgemein Halbleiter-Schaltungen und Halbleiter-Bauelemente. Im Speziellen betrifft die Erfindung die Herstellung von Halbleiter-Bauelementen für sehr hohe Frequenzen.

Typischerweise werden Halbleiterschaltungen auf oder in Halbleiter-Wafern hergestellt. Werden die Frequenzen der von der Schaltung zu verarbeitenden oder zu erzeugenden Signale sehr hoch, können durch das Vorhandensein des Halbleitersubstrats parasitische Kapazitäten entstehen, die zu erheblichen Verlustleistungen führen. Für Hochfrequenzanwendungen sind Schottky-Dioden als nichtlineare Elemente durch ihre elektrischen Eigenschaften besonders geeignet. Diese vorteilhaften Eigenschaften werden aber dann,je nach Bauweise der Schaltung durch parasitische Kapazitäten und dielektrische Verluste zumindest teilweise wieder aufgehoben.

Der Erfindung liegt daher die Aufgabe zugrunde, Halbleiter-Bauelemente zur Verfügung zu stellen, welche für einen weiten Frequenzbereich, sogar bis über Frequenzen von 1THz hinaus geeignet sind und dabei dielektrische Verluste zu verringern. Diese Aufgabe wird durch den Gegenstand der unabhängigen Ansprüche gelöst. Vorteilhafte Ausführungsformen und Weiterbildungen der Erfindung sind in den abhängigen Ansprüchen angegeben.

Demgemäß sieht die Erfindung ein Verfahren zur Herstellung von Halbleiter-Bauelementen, beziehungsweise Halbleiter-Schaltungen vor, bei welchem eine Kunststoffschicht hergestellt wird, die im fertiggestellten Bauteil den Träger für die Halbleiterstrukturen bildet..

Als Halbleiter-Schaltung wird im Sinne der Erfindung im einfachsten Falle ein Halbleiter-Schaltungselement mit elektrischen Kontakten zum Anschluss der Schaltung verstanden. In diesem Sinne kann eine Halbleiter-Schaltung somit auch ein einzelnes Halbleiter-Bauelement darstellen.

Ein erfindungsgemäß hergestelltes Halbleiter-Bauelement unterscheidet sich von bisherigen Versuchen, Halbleiter-Schaltungen auf Kunststoffsubstraten zu realisieren, in mehrfacher Weise.

Es wird insbesondere ein Halbleitersubstrat mit epitaktisch aufgewachsenen Halbleiterschichten verwendet. Die Kristallstrukturen der Halbleiterschichten sind demgemäß zueinander kommensurabel oder stehen zumindest in definierter Orientierung zueinander. Bei der bisher bekannten Abscheidung von Halbleiterschichten direkt auf einem Kunststoffträger können derartige Schichten nicht hergestellt werden. Epitaktische Schichten sind aber hinsichtlich ihrer elektrischen und halbleitenden Eigenschaften nicht epitaktischen, beispielsweise amorph oder polykristallin gewachsenen Schichten überlegen.

Weiterhin ist aufgrund der erfindungsgemäßen Herstellung die Grenzfläche zwischen der Kunststoffschicht und den Halbleiterstrukturen nicht eben, sondern verläuft entsprechend der dreidimensionalen Topographie des Halbleiter-Schaltungselements, während bei einer Abscheidung der Halbleiter auf einem Kunststoffsubstrat die Grenzfläche eben ist. Damit ist ein Halbleiter-Schaltungselement einer erfindungsgemäßen Anordnung, im Speziellen hervortretende, beziehungsweise erhabene Strukturen desselben teilweise in die Kunststoffschicht eingebettet. Mit anderen Worten sind erhabene Strukturen des Halbleiter-Schaltungselements vom Kunststoff der Kunststoffschicht umgeben. Außerdem können erfindungsgemäß vergleichsweise dünne Kunststoffträger mit Schichtdicken wie weiter unten angegeben verwendet werden.

Generell können mit der Erfindung Mesa-Strukturen von Halbleiter-Bauelementen sehr gut durch die Kunststoffschicht geschützt und passiviert werden.

Der freitragende Kunststoffträger verringert gegenüber einem Halbleitersubstrat insbesondere auch parasitische Kapazitäten erheblich. Damit sind erfindungsgemäße Bauelemente für höchste Frequenzen besonders geeignet. Besonders geeignet ist die Erfindung gerade auch für Halbleiter-Bauelemente und Schaltungen für hohe und höchste Frequenzen.

Da für hohe Frequenzen kleine Baugrößen günstig sind, um die Kapazitäten zu minimieren, sind derartige Bauelemente auch entsprechend sowohl gegenüber chemischen, als auch mechanischen Einflüssen empfindlich und werden durch die Einbettung in der Kunststoffschicht gut geschützt. Als Beispiel seien die für höchste Frequenzen gut geeigneten Schottky-Dioden mit ihren empfindlichen Metall-Halbleiter-Kontakten als Halbleiter-Bauelemente genannt.

Beispielsweise ergibt sich in Verbindung mit Schottky-Dioden ein weiterer Vorteil der Erfindung. Die Kunststoffschicht dient nicht nur als Träger, sondern schützt gleichzeitig auch den empfindlichen Schottky-Kontakt.

Für das erfindungsgemäße Verfahren wird zur Herstellung von Bauelementen oder integrierten Schaltungen mit zumindest einer Schottky-Diode aus den Halbleiterschichten eine Mesa-Struktur erzeugt und unter Ausbildung eines ersten Kontaktelements strukturiert, welche die Mesa-Struktur unter Bildung eines Schottky-Kontakts kontaktiert, und wobei die Kunststoffschicht auf das Halbleitersubstrat aufgebracht wird, so daß sie die Mesa-Struktur und den Schottky-Kontakt einbettet.

Mit dem Verfahren wird eine erfindungsgemäße mit zumindest einem Halbleiter-Schaltungselement, wobei das Halbleiter-Schaltungselement
- funktionelle epitaktische Halbleiterschichten umfasst, und wobei die Halbleiter-Schaltung
- eine Kunststoffschicht umfasst, welche das Halbleiter-Schaltungselement abdeckt und einbettet und einen freitragenden Träger für das Halbleiter-Schaltungselement bildet.

Das Verfahren ist für die Herstellung von Halbleiter-Schaltungselementen insbesondere in Form von Transistoren und Dioden geeignet. Gegebenenfalls können für bestimmte Halbleiter-Schaltungselemente auch mehr als zwei Halbleiterschichten verwendet werden.

Die mit dem Verfahren herstellbare Halbleiter-Schaltung umfasst demgemäß zumindest ein Halbleiter-Schaltungselement, wobei das Halbleiter-Schaltungselement
- funktionelle, also für die Funktion des Halbleiter-Schaltungselements wesentliche oder ursächliche epitaktische Halbleiterschichten umfasst, und wobei die Halbleiter-Schaltung
- eine Kunststoffschicht aufweist, welche das Halbleiter-Schaltungselement abdeckt und einbettet und einen freitragenden Träger für das Halbleiter-Schaltungselement bildet.

Gemäß einer Ausführungsform der Erfindung wird eine Halbleiter-Schaltung mit zumindest einer Schottky-Diode als Halbleiter-Schaltungselement hergestellt. Dazu wird
- aus den Halbleiterschichten eine Mesa-Struktur erzeugt, und
- eine metallische Schicht aufgebracht wird, die unter Ausbildung eines ersten Kontaktelements strukturiert wird, welche die Mesa-Struktur unter Bildung eines Schottky-Kontakts kontaktiert, Dann wird die Kunststoffschicht auf das Halbleitersubstrat aufgebracht, so daß die Kunststoffschicht die Mesa-Struktur und den Schottky-Kontakt einbettet.

Dementsprechend umfasst eine Halbleiter-Schaltung gemäß dieser Ausführungsform der Erfindung zumindest eine Schottky-Diode, wobei die Halbleiter-Schaltung eine Mesa-Struktur, sowie eine metallische Schicht umfasst, welche so strukturiert ist, dass sie ein erstes Kontaktelement bildet, welche die Mesa-Struktur unter Bildung eines Schottky-Kontakts kontaktiert, und wobei die Kunststoffschicht das erste Kontaktelement abdeckt und den Schottky-Kontakt einbettet.

Die Erfindung wird zwar im Speziellen anhand der Herstellung von Schottky-Dioden erläutert, ist aber in gleicher Weise auch für andere Halbleiter-Schaltungselemente, beziehungsweise Schaltungen mit solchen Halbleiter-Schaltungselementen, wie andere Dioden oder Transistoren geeignet und umsetzbar.

Es ist also insbesondere vorgesehen, eine auf die Halbleiter-Strukturen aufgebrachte Kunststoffbeschichtung als vorzugsweise alleinigen Träger für die Schaltung zu verwenden, da das Halbleiter-Substrat nach dem Aufbringen der Kunststoff-Beschichtung entfernt wird. Überraschend ergibt dabei eine Kunststoffbeschichtung, insbesondere auch eine Rotationsbeschichtung mit Kunststoff einen hinreichend stabilen Träger. Dies reduziert nicht nur parasitische Kapazitäten und dielektrische Verluste und macht die erfindungsgemäßen Schaltungen besonders geeignet für Hoch-und Höchstfrequenz-Anwendungen, sondern führt im Allgemeinen auch zu einer verlustarmen Transmission hoch-und höchstfrequenter Felder durch die erfindungsgemäße Schaltungsanordnung. Dies ermöglicht es beispielsweise, eine erfindungsgemäße Schaltung zur Detektion elektromagnetischer Wellen einzusetzen, ohne die Feldverteilung wesentlich zu stören. Damit ist die Erfindung unter anderem bestens für Empfänger in der Radioastromie oder für Anwendungen Terahertz-Strahlungsbereich, wie etwa für Millimeterwellen- oder Submillimeterwellen-Bildscanner.

Um parasitische Kapazitäten möglichst gering zu halten, werden für die Kunststoffbeschichtung Kunststoffe mit einer Dielektrizitätskonstante εᵣ < 4 bevorzugt.

Das Aufbringen des Kunststoffs erfolgt besonders bevorzugt durch Rotations-, beziehungsweise Schleuderbeschichtung. Prinzipiell sind aber auch andere Beschichtungsverfahren, wie etwa Tauchbeschichtung, Vorhanggiessen oder Siebdruck möglich. Eine Heißbeschichtung mit geschmolzenem Kunststoffmaterial ist jedoch weniger bevorzugt für bestimmte Bauelemente. Als Beispiel seien wiederum Schottky-Dioden genannt, da Temperaturen oberhalb von 150 °C den Schottky-Kontakt beeinträchtigen können.

Die Kunststoffschicht bildet zwar am fertiggestellten Bauelement, beziehungsweise der einsatzbereiten Halbleiterschaltung einen freitragenden Träger, allerdings erschwert dies die Handhabung während der Fertigung. Es ist daher in bevorzugter Weiterbildung der Erfindung vorgesehen, während der Fertigungsschritte noch einen stabilen Träger zu verwenden. Demgemäß ist vorgesehen, dass die Halbleiter-Schaltung mit der Kunststoffschicht auf einem Trägerteil befestigt und anschließend das Halbleitersubstrat entfernt wird, wobei nach dem Entfernen des Halbleitersubstrats und gegebenenfalls weiterer Verfahrensschritte, wie etwa dem Aufbringen zweiter metallischer Kontakte auf den nach Entfernen des Halbleitersubstrats freigelegten epitaktischen Halbleiterschichten das Trägerteil entfernt wird, so dass die Kunststoffschicht nach dem Entfernen des Trägerteils den freitragenden Träger für das Halbleiter-Schaltungselement bildet.

Insbesondere können auf diese Weise bei paralleler Fertigung mehrerer Halbleiter-Schaltungen ausgehend von einem Halbleitersubstrat mit darauf abgeschiedenen epitaktischen Schichten die einzelnen Schaltungen sehr bequem durch Auftrennen der Kunststoffschicht getrennt werden. Dazu ist vorgesehen, dass aus den Halbleiterschichten mehrere Halbleiter-Schaltungen hergestellt werden, wobei die Kunststoffschicht vor dem Befestigen auf dem Trägerteil oder während die Kunststoffschicht auf dem Trägerteil befestigt ist, aufgetrennt wird, so dass nach dem Entfernen des Trägerteils vereinzelte Halbleiter-Schaltungen erhalten werden. Es kann also entweder das Trägerteil oder - was bevorzugt wird- das Halbleitersubstrat als Träger während des Schrittes des Auftrennens der Kunststoffschicht dienen.

Generell, ob mit oder ohne Verwendung eines Trägerteils ist es besonders von Vorteil, wenn der Kunststoff der Kunststoffschicht zwischen den Halbleiterschaltungen photolithographisch entfernt werden kann. Dies erlaubt es, die Vereinzelung der einzelnen Halbleiterschaltungen ohne größere mechanische Beanspruchung vorzunehmen, wie sie etwa sonst beim Zersägen von Halbleiterwafern auftritt.

Im einfachsten Fall umfasst eine erfindungsgemäße Schaltung lediglich eine oder mehrere Halbleiter-Schaltungselemente, beispielsweise Schottky-Dioden, mit elektrischen Anschlüssen. Es ist aber auch möglich, weitere elektronische Komponenten zusammen mit der oder den Halbleiter-Schaltungselementen herzustellen. Besonders einfach ist dabei die Herstellung von passiven Elementen, wie planare Filter, Kondensatoren, Induktivitäten und verschiedenen Kopplungselementen, beispielsweise Antennenstrukturen. Diese Elemente können in einfacher Weise durch Strukturierung der Metallschichten erzeugt werden, die auch zur Kontaktierung der Halbleiter-Schaltungselemente eingesetzt werden.

Die Erfindung ist insbesondere für die Herstellung von Schaltungen für sehr hohe Frequenzen im Bereich ab 10 GHz geeignet. Beispielsweise können erfindungsgemäß hergestellten Schottky-Dioden in Verbindung mit passiven elektronischen Bauelementen in integrierten Schaltungen als Detektoren oder Demodulatoren für Hoch- und Höchstfrequenzwechselfelder eingesetzt werden. Weitere Anwendungen sind Frequenzvervielfacher, wie etwa Frequenzverdoppler oder Frequenzverdreifacher, und Frequenzmischer für Heterodyn-Detektoren.

Neben Schottky-Dioden können mit der Erfindung auch andere Bauelemente, sowie integrierte Schaltungen mit solchen Bauelementen auf Kunststoffträger hergestellt werden. Solche Bauelemente sind beispielsweise resonante Tunneldioden (RTD), HBV (Heterobarriere-Varaktordioden), Transistoren. Diese Bauelemente können dann ebenfalls oder ergänzend für die Detektion, Erzeugung und Bearbeitung hochfrequenter elektromagnetischer Felder eingesetzt werden. Generell ist die Erfindung auf alle Arten von Halbleiter-Schaltungselementen anwendbar.

Die Erfindung wird nachfolgend anhand von Ausführungsbeispielen und unter Bezugnahme auf die Zeichnungen näher erläutert. Dabei verweisen gleiche Bezugszeichen in den Zeichnungen auf gleiche oder entsprechende Elemente. Es zeigen:
Fig. 1 bis Fig. 6 anhand von Querschnittansichten Verfahrensschritte zur Herstellung der Mesa-Strukturen,
Fig. 7 bis 9 weitere Verfahrensschritte zur Herstellung erfindungsgemäßer Schaltungen,
Fig. 10 eine Weiterbildung der in Fig. 9 dargestellten Ausführungsform mit weiterer Kunststoffschicht,
Fig. 11 bis Fig. 13 eine Variante der in den Fig. 1 bis 9 gezeigten Verfahrensschritten.
Fig. 15A und Fig. 15B einen Träger mit mehreren Schaltungen,
Fig. 16A bis 16C Ausführungsbeispiele von Umrissformen erfindungsgemäßer Halbleiter-Schaltungen,
Fig. 17 eine Detektorschaltung,
Fig. 18 eine Abwandlung der Schaltung aus Fig. 16,
Fig. 19 eine Detektorschaltung in einem Hohlleiter, und
Fig. 20 und 21 zwei Ausführungsbeispiele mit elektrischen Anschlusskontakten, die aus einer in der Kunststoffschicht eingebetteten Metallschicht ausgebildet sind.

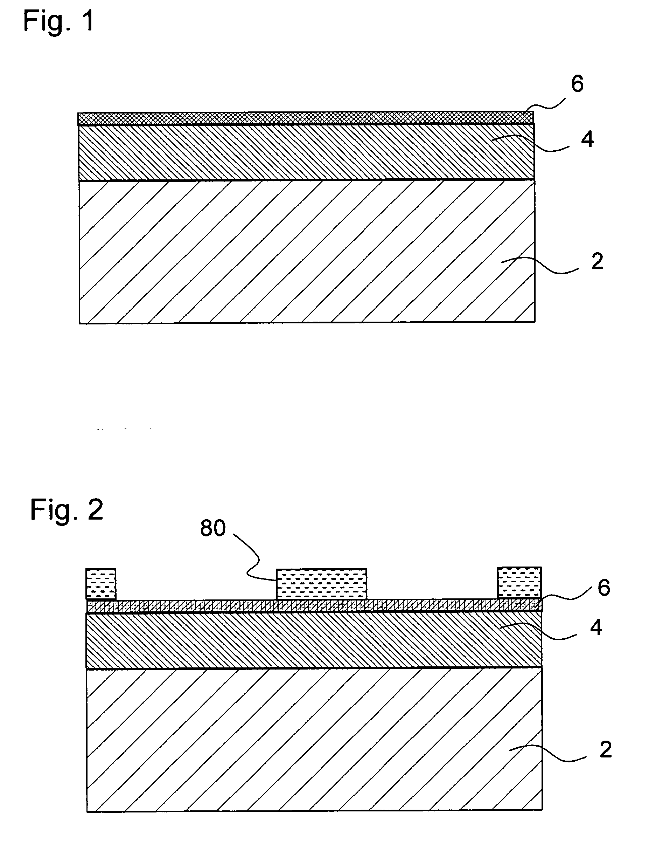

Anhand der Fig. 1 bis Fig. 6 wird die Herstellung einer erfindungsgemäßen Schaltung erläutert. Als Halbleitersubstrat 2 wird in diesem Beispiel ein Indiumphosphid-Substrat mit epitaktischen, kristallinen Halbleiterschichten, vorzugsweise in Gestalt eines Wafers verwendet.

Zunächst werden gemäß diesem Ausführungsbeispiel zwei Mesa-Strukturen mit Metallkontakten hergestellt. Dieses Verfahren basiert auf folgenden Schritten:
- auf das Substrat wird eine ein- oder mehrlagige Metallschicht zur Herstellung des ersten Kontaktelements abgeschieden und strukturiert, wobei das Strukturieren der Metallschicht das Ausbilden eines Kontaktfingers, welcher auf der zweiten Halbleiterschicht endet,
- die Halbleiterschichten werden in einem Bereich unter dem ersten Kontakt unter Ausbildung einer Lücke entfernt, wobei die zweite Halbleiterschicht zumindest in einem Bereich unter dem Kontaktfinger erhalten bleibt, so dass zwei lateral beabstandete, über den Kontaktfinger elektrisch miteinander verbundene, durch die Lücke getrennte Mesa-Strukturen erhalten werden.

Wie in Fig. 1 dargestellt, wird ein Halbleitersubstrat 2 mit einer ersten, dotierten Halbleiterschicht 4 und einer auf der ersten dotierten Halbleiterschicht 4 angeordneten zweiten Halbleiterschicht 6 verwendet, wobei die beiden Halbleiterschichten unterschiedlich dotiert sind. Insbesondere können die Halbleiterschichten in Weiterbildung der Erfindung und ohne Beschränkung auf das in den Figuren beschriebene Ausführungsbeispiel zwar mit gleichem Vorzeichen, aber mit unterschiedlicher Ladungsträgerkonzentration dotiert sein. Typischerweise ist die Ladungsträgerkonzentration der zweiten Halbleiterschicht 6 geringer als die Ladungsträgerkonzentration der ersten Halbleiterschicht,. Damit wird in einfacher Weise erreicht, dass ein Metallkontakt auf der zweiten Halbleiterschicht einen Schottky-Kontakt und ein Metallkonktakt zur ersten Halbleiterschicht einen ohmschen Kontakt bildet. Vorzugsweise ist dazu die Ladungsträgerkonzentration in der ersten Halbleiterschicht 4 größer als 10¹⁸/cm³ und die Ladungsträgerkonzentration in der zweiten Halbleiterschicht 6 kleiner als 10¹⁸/cm³. Bevorzugt beträgt die Ladungsträgerkonzentration der ersten Halbleiterschicht mindestens 3*10¹⁸/cm³ und die Ladungsträgerkonzentration der zweiten Halbleiterschicht höchstens 1*10¹⁸/cm³. Eine weitere Möglichkeit ist, verschiedene Halbleitermaterialien für die Schichten zu verwenden. In jedem Fall sind die Halbleiterschichten 4, 6 epitaktisch aufgewachsen, so dass die Kristallstrukturen der kristallinen Halbleiterschichten zueinander eine definierte Orientierung aufweisen.

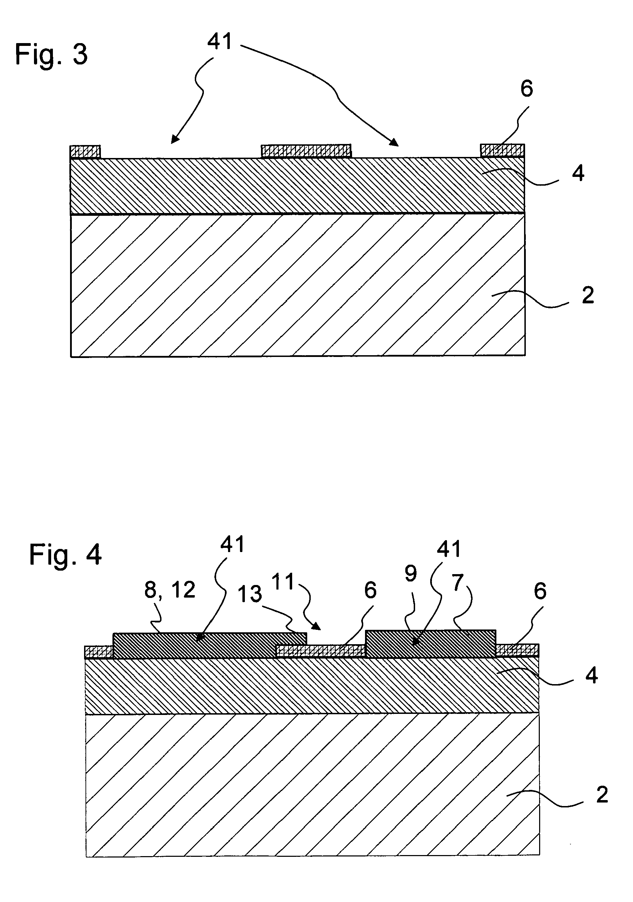

Um die zweite Halbleiterschicht 6 selektiv in zumindest einem ersten Bereich zu entfernen, wird zunächst, wie in Fig. 2 gezeigt, eine strukturierte Zwischenschicht 80 hergestellt, welche die zu entfernenden Bereiche der zweiten Halbleiterschicht 6 freilässt, andere Bereiche der Halbleiterschicht 6 dagegen bedeckt. Für die Zwischenschicht 80 kann in einfacher Weise ein Photoresist verwendet werden, der photolithographisch strukturiert wird. Anschließend wird die zweite Halbleiterschicht 6 durch Ätzen in den von der Zwischenschicht 80 freigelassenen Bereichen entfernt. Anschließend wird die als Ätzmaske dienende Zwischenschicht 80 entfernt. Das Ergebnis ist in Fig. 3 dargestellt. Durch die vorstehend beschriebenen Schritte ist nun ein Bereich 41, bei dem gezeigten Beispiel im Speziellen in zwei Bereichen 41 die zweite Halbleiterschicht 6 entfernt und die erste Halbleiterschicht 4 in diesen Bereichen freigelegt. Anders als in Fig. 3 dargestellt, kann die erste Halbleiterschicht 4 in dem oder den Bereichen 41 ebenfalls ganz oder teilweise entfernt sein.

Gemäß einer Ausführungsform der Erfindung werden die Halbleiterschichten 4, 6 aus InGaAs hergestellt. Dieser Halbleiter zeichnet sich unter anderem dadurch aus, dass mit einem InP-Substrat die Halbleiterschichten leicht epitaktisch abgeschieden werden können. Weiterhin können die Halbleiterschichten durch Ätzen selektiv entfernt werden, ohne das Substrat wesentlich anzuätzen und umgekehrt das Substrat selektiv durch Ätzen entfernt werden, ohne dass die verbleibenden Bereiche der Halbleiterschichten entfernt werden.

In einem nächsten Schritt wird auf die erste und zweite Halbleiterschicht eine ein- oder mehrlagige Metallschicht 7 zur Herstellung des ersten metallischen Kontaktes abgeschieden und strukturiert. Das Ergebnis ist in Fig. 4 gezeigt. Die Metallschicht 7 wird hier unter Bildung zweier metallischer Kontakte 8, 9 ausgebildet, wobei jeweils einer der Kontakte 8, 9 einen der Bereiche 41 kontaktiert. Der Kontakt 8 bildet dabei das erste Kontaktelement 12 für die Schottky-Diode.

Weiterhin wird die Metallschicht 7 so strukturiert, dass eine laterale Lücke 11 der Metallschicht 7 im Bereich zwischen den beiden auszubildenden Mesa-Strukturen, in welchem die zweite Halbleiterschicht 6 angeordnet ist erhalten wird. Diese Lücke dient dazu, zwei elektrisch getrennte Kontakte aus der Metallschicht 7 auszubilden. Außerdem wird der Kontakt 8 mit einem Kontaktfinger 13 oder allgemein einem Kontaktbereich, welcher auf der zweiten Halbleiterschicht 6 endet, ausgebildet.

Das Strukturieren der Metallschicht, wie sie schematisch in Fig. 4 gezeigt ist, erfolgt vorzugsweise durch Abscheiden auf eine strukturierte Zwischenschicht und anschließendem Lift-off. Demgemäß wird nach dieser Weiterbildung der Erfindung zur Abscheidung und Strukturierung der auf den Halbleiterschichten angeordneten ersten metallischen Kontakte und damit des ersten Kontaktelements, welches den Schottky-Kontakt herstellt, zumindest eine Metallschicht abgeschieden, wobei vor dem Abscheiden der zumindest einen Metallschicht eine strukturierte Zwischenbeschichtung aufgebracht wird und die laterale Strukturierung der ersten metallischen Kontakte durch Entfernen der Zwischenbeschichtung zusammen mit den auf der Zwischenbeschichtung angeordneten Bereichen der zumindest einen Metallschicht erfolgt.

Ebenso möglich ist eine nachträgliche Strukturierung der Metallschicht durch Aufbringen einer Photoresist-Schicht, photolithographisches Strukturieren der Photoresist-Schicht, Entfernen der freiliegenden, beziehungsweise von der Photoresist-Schicht nicht bedeckten Bereiche der Metallschicht, vorzugsweise durch Ätzen.

Gemäß einer Ausführungsform der Erfindung wird die Metallschicht 7 dreischichtig hergestellt. Besonders geeignet ist dabei eine Titan/Platin/Gold-Beschichtung. Titan ist als Kontaktmaterial für den Halbleiter besonders geeignet. Gold wiederum dient zur Verbesserung der Leitfähigkeit und die Platinschicht wirkt als Barriere gegen die Diffusion von Gold in den Halbleiter. Soll die Metallschicht 7 geätzt werden, ist es aber günstig, die Platinschicht wegzulassen, da Platin nur schwer zu ätzen ist.

Gemäß dieser Weiterbildung der Erfindung wird zur Herstellung der ersten metallischen Kontakte 8, 9, beziehungsweise des ersten Kontaktelements eine mehrlagige Metallschicht abgeschieden, wobei auf einer Titan-Schicht eine Platin-Schicht und auf der Platin-Schicht eine Gold-Schicht abgeschieden wird. Titan als Material für den Metall-Halbleiter-Kontakt ist aufgrund der niedrigen Austrittsarbeit günstig, um eine niedrige Durchlassspannung der Diode zu erreichen, um eine Zero-Bias-Diode herzustellen.

Auch andere Schottky-Diodentypen, wie etwa Varaktor-Dioden oder allgemein Dioden mit höheren Durchlassspannungen können durch Wahl des Metalls und der Halbleiter erzeugt werden. Während Zero-Bias-Dioden besonders als Detektor geeignet sind, können Dioden mit höheren Durchlassspannungen unter anderem dazu verwendet werden, höhere Harmonische zu erzeugen und damit Frequenzvervielfachungen durchzuführen oder um Frequenzmischer für Heterodyn-Empfänger aufzubauen.

Die Dicke der ein- oder mehrlagigen Metallschicht 7 liegt vorzugsweise zwischen 20 nm und 2000 nm.

Die strukturierte Metallschicht kann weiterhin auch so hergestellt werden, dass mit der Metallschicht Anschlussleitungen und elektronische Bauelemente gebildet werden. Solche Bauelemente können insbesondere Antennenstrukturen, sowie induktive, kapazitive und resistive Bauelemente umfassen. Auf diese Weise werden mit nur einem Metallisierungs-Prozess sowohl der Schottky-Kontakt, als auch elektrische Leiterbahnen und gegebenenfalls passive Bauelemente hergestellt. Durch die Kombination einer oder mehrerer Dioden mit passiven elektrischen Bauelementen können auf diese Weise erfindungsgemäße Halbleiter-Bauelemente, beziehungsweise Halbleiter-Schaltungen als integrierte Schaltungen ausgebildet werden. Als integrierte Schaltung oder integriertes Bauelement im Sinne der Erfindung wird allgemein eine Diode oder eine Anordnung von Dioden (beziehungsweise ein Diodenarray) in Verbindung mit ebenfalls auf dem Kunststoffträger angeordneten, insbesondere aus den Metallschichten ausgebildeten passiven Elementen verstanden. Solche passiven Elemente können insbesondere Antennenstrukturen, kapazitive und resistive Strukturen sein.

Als nächster Schritt erfolgt die Ausbildung der Mesa-Strukturen, indem im Bereich der Lücke 11 zwischen den Kontakten 8, 9, genauer gesagt unter dem Kontaktfinger 13, die Halbleiterschichten 4 und 6 durch Ätzen entfernt werden.

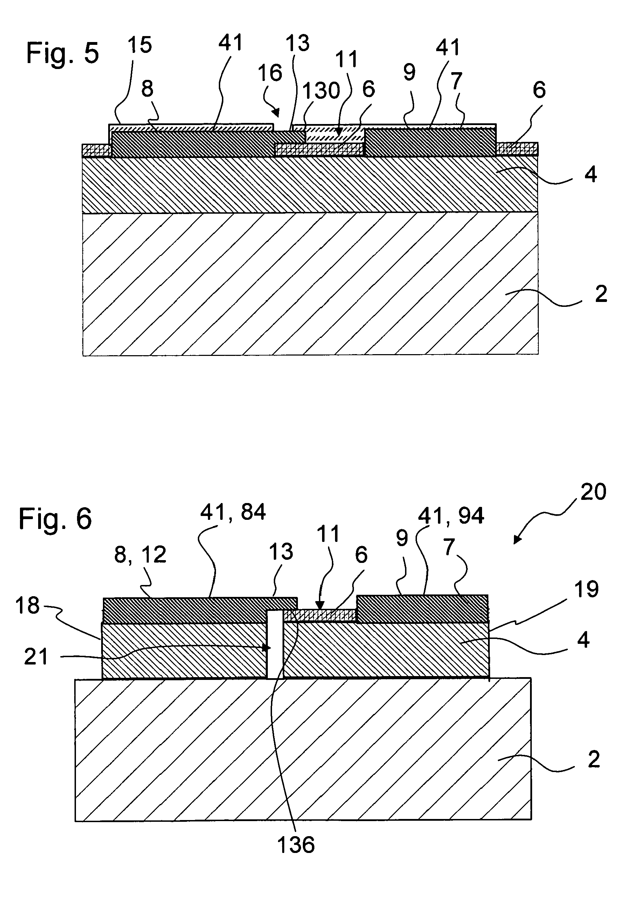

Dazu wird, wie in Fig. 5 dargestellt, auf die mit der strukturierten Metallschicht 7 versehenen Halbleiterschichten 4,6 eine Photoresist-Schicht 15 aufgebracht und photolithographisch strukturiert, so dass Bereiche der Photoresist-Schicht 15 unter Bildung eines Spalts 16 entfernt werden. Der Spalt 16 befindet sich, wie anhand von Fig. 5 zu erkennen ist, im Bereich des Kontaktfingers 13, wobei aber das Ende 130 des Kontaktfingers 13 von der Photoresist-Schicht 15 bedeckt bleibt.

Anschließend werden die Halbleiterschichten in den freiliegenden Bereichen, also auch im Bereich des Spalts 16 selektiv entfernt, so dass zwei Mesa-Stukturen 18, 19, welche durch einen Spalt 21 getrennt sind, erhalten werden.

Das Entfernen der Halbleiterschichten 4,6 im Bereich des Spaltes 16 erfolgt besonders bevorzugt durch Ätzen. Es kommen sowohl Nass-, als auch Trockenätzverfahren, wie etwa Plasmaätzen in Betracht.

Die Photoresist-Schicht 15 wird danach entfernt. Das Ergebnis ist in Fig. 6 gezeigt.

Durch das Ätzen werden im Bereich der Lücke 11 in der Metallschicht 7 unter Ausbildung eines Spalts 21 die Halbleiterschichten 4, 6 entfernt, wobei aber die zweite Halbleiterschicht 6 zumindest in einem Bereich unter dem Kontaktfinger 13 erhalten bleibt, so dass zwei lateral durch den Spalt 21 beabstandete, über den Kontaktfinger 13, welcher den Spalt 21 überbrückt, elektrisch miteinander verbundene Mesa-Strukturen 18, 19 erhalten werden.

Der Kontakt am Ende des Kontaktfingers 13 zur zweiten Halbleiterschicht der gegenüberliegenden Mesa-Struktur 19 bildet einen Schottky-Kontakt 136. Demgegenüber bilden die ersten metallischen Kontakte 8, 9 an den Bereichen 41 jeweils ohmsche Kontakte 84, beziehungsweise 94. Dies kann in einfacher Weise durch geeignete Dotierung der Halbleiterschichten 4, 6 erreicht werden. Um zu vermeiden, dass sich in den Bereichen 41 ebenfalls Schottky-Kontakte ausbilden, wird für die Halbleiterschicht 4 ein höherer Dotierungsgrad als für die Halbleiterschicht 6 eingesetzt. Die über den Kontaktfinger 13 kontaktierte Mesa-Struktur 19 bildet nun eine Schottky-Diode 20.

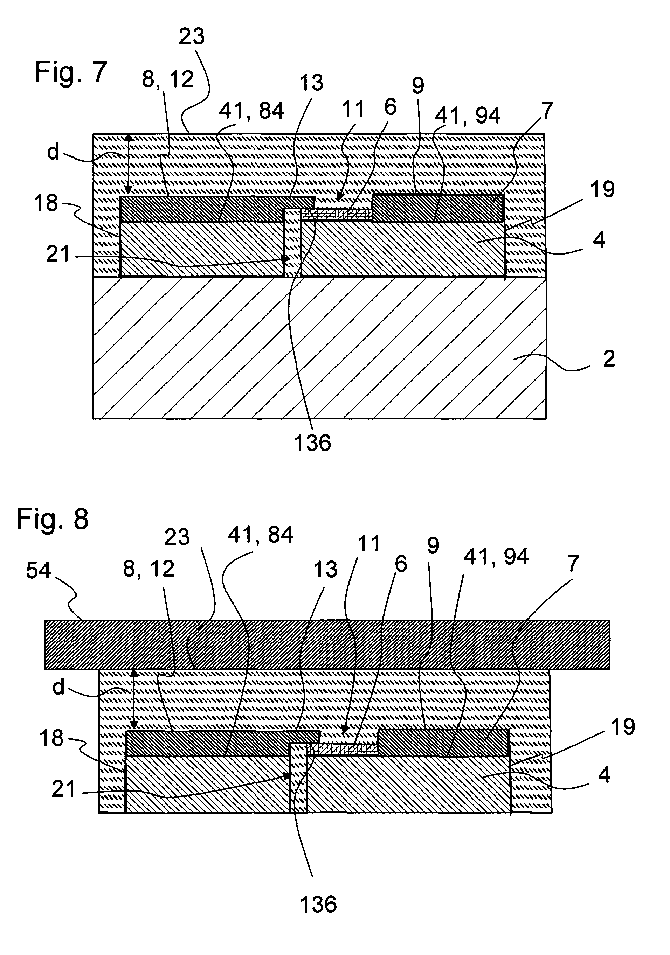

Auf dem Halbleitersubstrat 2 auf der Seite, auf welcher wie oben beschrieben die Mesa-Strukturen 18, 19 hergestellt wurden, wird, wie in Fig. 7 gezeigt, eine Kunststoffschicht 23 durch Schleuderbeschichten aufgebracht. Die Schichtdicke der Kunststoffschicht 23 beträgt dabei vorzugsweise weniger als 20 Mikrometer, besonders bevorzugt zwischen 2 bis 20 Mikrometern. Wie anhand von Fig. 7 ersichtlich ist, füllt die Kunststoffschicht 23 auch den Spalt 21 und deckt damit nicht nur den Kontaktfinger 13 mit dem Schottky-Kontakt 136 ab, sondern bettet diese auch ein. Auf diese Weise wird eine mechanische Stabilisierung und eine chemische Passivierung des Schottky-Kontakts bewirkt.

Generell können zur Herstellung der Kunststoffschicht 23 alle in einem Lösungsmittel lösbare, oder auch härtbare Kunststoffe eingesetzt werden, um diese in flüssiger Form, beispielsweise als Polymerlösung aufzutragen und durch die Rotationsbeschichtung auf dem Halbleitersubstrat 2 zu verteilen. Gut geeignet sind unter anderem dabei auch Photoresist-Kunststoffe, wie Epoxidharze oder BCB-basierte Polymere.

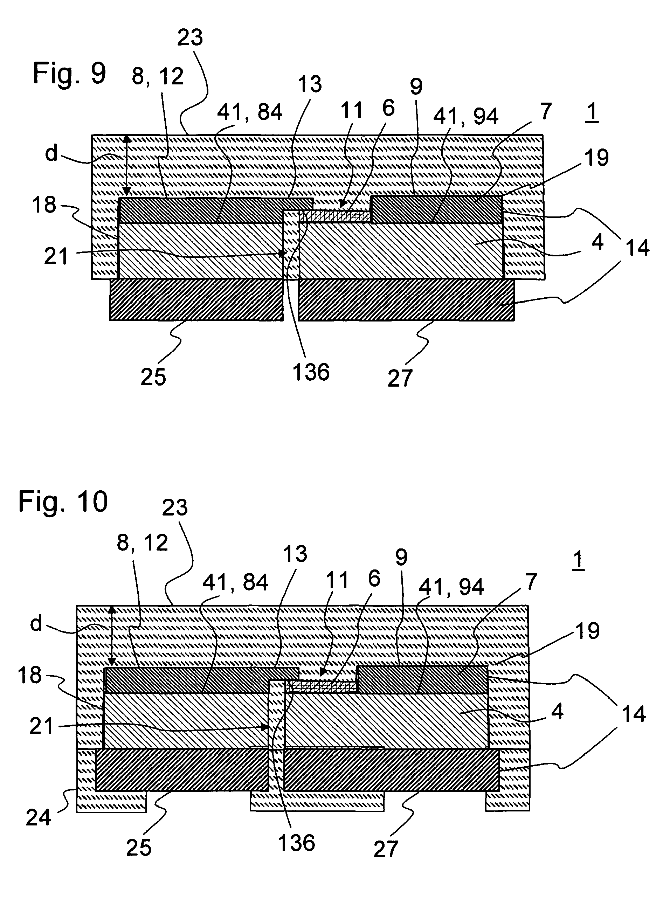

Nach dem Rotationsbeschichten und dem Aushärten der Kunststoffschicht 23 wird die Halbleiter-Schaltung mit der Kunststoffschicht 23 auf einem Trägerteil 54, beispielsweise einem Wafer befestigt. Beispielsweise kann die Kunststoffschicht 23 auf das Trägerteil 54 mit einem lösbaren Klebstoff fixiert werden. Die Befestigung auf dem Trägerteil 54 dient dazu, die Handhabbarkeit während der weiteren Fertigungsschritte zu erleichtern und während der Fertigung die Struktur mechanisch zu unterstützen. Das Halbleitersubstrat 2 wird nun entfernt. Während der nachfolgenden auch anhand der Fig. 9 bis Fig. 14 beispielhaft erläuterten Prozessschritte bleibt die Halbleiter-Schaltung 1 auf dem Trägerteil 54 fixiert. Nach der Fertigstellung wird dann das Trägerteil 54 entfernt, beispielsweise durch Lösen der Klebstoff-Verbindung, so dass die Halbleiter-Schaltung mit freitragender Kunststoffschicht erhalten wird. Zum Zwecke der Übersichtlichkeit ist aber in den nachfolgenden Fig. 9 bis Fig. 14 das Trägerteil 54 nicht dargestellt.

Diese Kunststoffschicht 23 bildet dann für das fertiggestellte Bauteil mit den Mesa-Strukturen 18, 19einen freitragenden Träger. Epoxidharz oder Benzozyklobuten-Polymer sind als Kunststoffe besonders geeignet, um dazu eine hinreichende Stabilität für den Träger bereitzustellen.

Die später als Träger für die Schaltung dienende Kunststoffschicht 23 hat gegenüber einem Halbleitersubstrat als Träger erhebliche Vorteile für die Eignung der Schaltung für höchste Frequenzen. Geeignete Halbleitersubstrate weisen üblicherweise hohe Dielektrizitätskonstanten auf. So beträgt die Dielektrizitätskonstante εr von Indiumphosphid etwa 11. Dies führt, insbesondere auch, da eine gewisse Mindestdicke für das Halbleitersubstrat erforderlich ist, zu erheblichen parasitären Kapazitäten. Die dielektrischen Verluste werden ebenfalls deutlich reduziert, da mit der Kunststoffschicht verglichen mit dem Halbleitersubstrat weniger Material im Bereich der ein- oder abgestrahlten elektromagnetischen Felder vorhanden ist.

Allerdings sind nun die ersten metallischen Kontakte 8, 9 in die Kunststoffschicht 23, beziehungsweise in den Träger eingebettet und damit nicht ohne weiteres mehr zugänglich. Außerdem liegt die erste Halbleiterschicht 4 nach dem Entfernen des Halbleitersubstrats nun offen.

Um die so freigelegten Mesa-Strukturen 18, 19 einerseits zu verkapseln und andererseits auch eine Kontaktierung der Schaltung zu ermöglichen, werden, wie in Fig. 9 gezeigt, zweite metallische Kontakte 25, 27 auf die freigelegten Bereiche der Halbleiterschicht 4, beziehungsweise auf die Mesa-Strukturen 18, 19 auf der Seite, auf welcher zuvor das Halbleitersubstrat angeordnet war, abgeschieden.

Wie auch die ersten metallischen Kontakte 8, 9 können die zweiten metallischen Kontakte 25, 27 durch Lift-off strukturiert werden, indem zunächst eine Zwischenbeschichtung aufgebracht und strukturiert wird, so dass die Bereiche mit der freiliegenden Unterseite der Mesa-Strukturen 18, 19 offen bleiben. Nach Abscheiden der Metallschicht und dem Ablösen der Zwischenschicht verbleiben die metallischen Kontakte 25, 27.

Auch für die zweiten metallischen Kontakte 25, 27 kann eine mehrschichtige Metallschicht verwendet werden. Geeignet ist beispielsweise eine Titan-Gold-Beschichtung. Da die zweiten metallischen Kontakte 25, 27 auch zur Verkapselung und für den Anschluss der Schaltung an weitere Komponenten, wie etwa eine Auswerteschaltung verwendet werden, wird für diese Kontakte eine dickere Metallschicht bevorzugt. Ein geeigneter Dickenbereich für die zweiten metallischen Kontakte 25, 27 liegt dabei zwischen 0,1 *µ*m und 10*µ*m.

Mit der Ausbildung der zweiten metallischen Kontakte 25, 27 sind die grundlegenden Schritte für die Herstellung einer erfindungsgemäßen Schaltung 1, beziehungsweise eines Halbleiter-Bauelelements abgeschlossen. Die Halbleiter-Schaltung 1, wie sie Fig. 9 zeigt, weist demgemäß Halbleiterschichten in Form einer ersten dotierten Halbleiterschicht 4, auf welcher eine zweite dotierte Halbleiterschicht 6 angeordnet ist, auf, und wobei auf der zweiten Halbleiterschicht 6 die ersten metallischen Kontakte 8, 9 angeordnet sind und die zweite Halbleiterschicht 6 mit den ersten metallischen Kontakten 8, 9 im durch die Kunststoffschicht 23 gebildeten Träger eingebettet ist. Auch bei der Abscheidung der Metallschicht für die zweiten metallischen Kontakte können Elemente der Schaltung ausgebildet werden. Diese Elemente können wiederum Leiterbahnen und passive Bauelemente, wie Widerstände, kapazitive und induktive Elemente, sowie Antennen umfassen. Insbesondere können auch Anschlussflächen hergestellt werden, welche zum Anschluss der Schaltung dienen und mit den metallischen Kontakten 25, 27 über Leiterbahnen verbunden sind.

Optional kann eine weitere Kunststoffschicht 24, wie in Fig. 10 gezeigt, auf der Seite mit den zweiten metallischen Kontakten 25, 27 aufgebracht werden. Diese kann dazu dienen, die nicht zum Anschluss verwendeten Teile der Metallschicht, aus welcher auch die Kontakte 25, 27 gebildet werden, zu schützen, gegebenenfalls auch die Kunststoffschicht 23 mechanisch zu verstärken.

Bei der anhand der vorstehend beschriebenen beispielhaften Herstellung des erfindungsgemäßen Halbleiter-Bauelements bilden sowohl der metallische Kontakt 9, als auch der zweite metallische Kontakt 27 auf der Mesa-Struktur 19 mit dem Schottky-Kontakt jeweils ein zweites Kontaktelement 14, welches einen ohmschen Kontakt mit der ersten Halbleiterschicht 4 der Schottky-Diode des Mesas 19 herstellt. Dies ist unter anderem dann von Vorteil, wenn aus den Metallschichten beider Kontaktelemente 14 passive Bauelemente zur Herstellung einer integrierten Schaltung hergestellt werden sollen. In vielen Fällen ist dies aber nicht erforderlich. Generell können daher für die grundlegende Funktion des Bauelelements eines der zweiten Kontaktelemente, oder auch alle zweiten Kontaktelemente weggelassen werden. Gemäß noch einer Weiterbildung der Erfindung kann es günstig sein, zwischen den metallischen Kontakten auf den beiden Seiten der Mesa-Strukturen 18, 19, also zwischen den Kontakten 8 und 25 und/oder den Kontakten 9 und 27 einen direkten elektrischen Kontakt zu schaffen. Mit anderen Worten wird gemäß dieser Ausführungsform der Erfindung eine Durchkontaktierung zwischen den ohmschen Kontakten zumindest eines der Mesa-Strukturen des Halbleiter-Bauelements hergestellt.

Ohne Beschränkung auf das spezielle, in den Figuren dargestellte Ausführungsbeispiel der Erfindung ist daher gemäß einer Ausführungsform der Erfindung eine Halbleiter-Schaltung vorgesehen, bei welcher zumindest ein metallischer Kontakt für die Halbleiterschichten 4,6, auf welchem die Kunststoffschicht 23 aufgebracht ist, mit einem zweiten metallischen Kontakt 25, 27 auf der gegenüberliegenden Seite der Halbleiterschichten 4, 6 direkt elektrisch kontaktiert ist.

Das entsprechende Herstellungsverfahren basiert dann darauf, dass zumindest einer der zweiten metallischen Kontakte 25, 27 auf einem ersten metallischen Kontakt 8, 9, auf welchem die Kunststoffschicht 23 aufgebracht ist, abgeschieden wird und damit den ersten metallischen Kontakt 8, 9 direkt elektrisch kontaktiert.

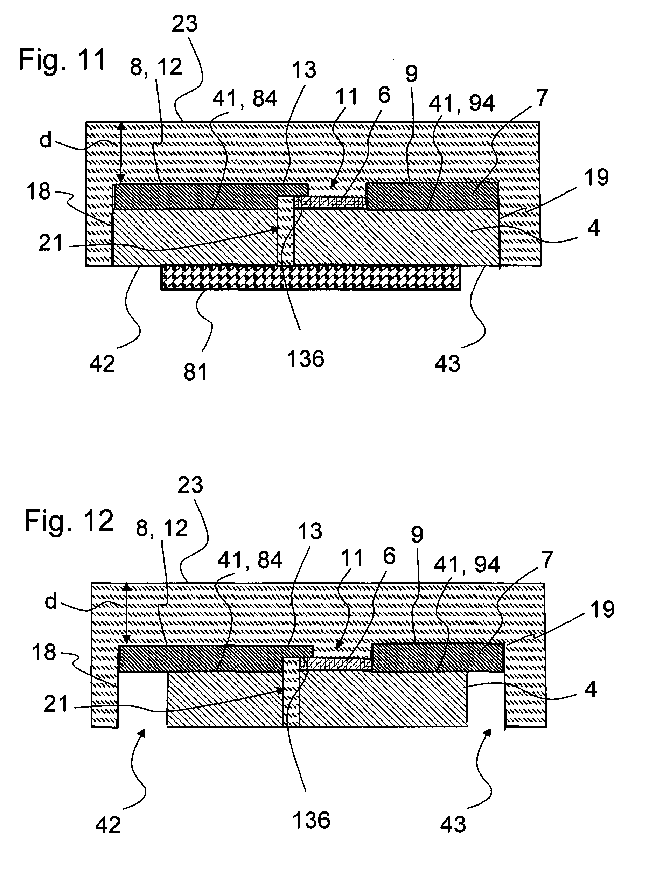

Fig. 11 zeigt dazu das Zwischenerzeugnis gemäß der in Fig. 8 gezeigten Fertigungsstufe. Die durch das Entfernen des Halbleitersubstrats freigelegte erste Halbleiterschicht 4 wird nun mit einer strukturierten Zwischenschicht 81 maskiert. Die Zwischenschicht 81 lässt dabei Bereiche 42, 43 frei. Bei dem in Fig. 11 gezeigten Beispiel ist dabei jeweils ein Bereich 42, 43 auf einer der die Mesa-Strukturen bildenden beiden Teile der ersten Halbleiterschicht 4 angeordnet. Die erste Halbleiterschicht 4 wird nun weggeätzt und die Zwischenschicht 81 wird entfernt. Das Ergebnis ist in Fig. 12 gezeigt. Durch das Entfernen der ersten Halbleiterschicht 4 sind die metallischen Kontakte 8, 9, beziehungsweise die Metallschicht 7 in diesen Bereichen 42, 43 freigelegt.

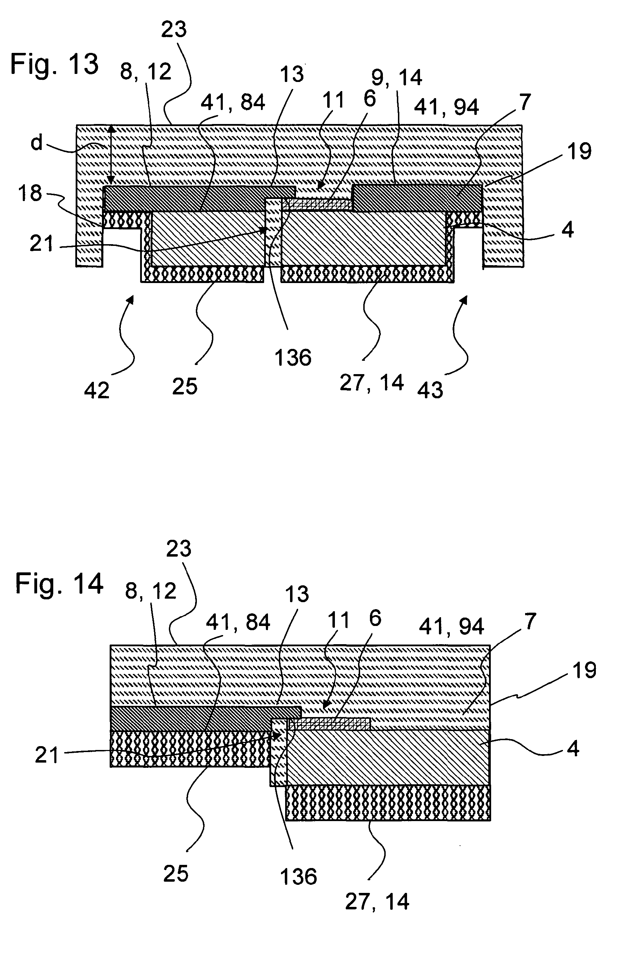

Anschließend wird entsprechend zu Fig. 9 eine Metallschicht abgeschieden und unter Ausbildung der zweiten metallischen Kontakte 25, 27 auf der Seite, auf welcher zuvor das Halbleitersubstrat angeordnet war, strukturiert. Das Ergebnis zeigt Fig. 13. Im Unterschied zu dem in Fig 9 gezeigten Beispiel sind hier die metallischen Kontakte 8, 9 jeweils mit den zweiten metallischen Kontakten direkt verbunden. Eine solche Durchkontaktierung kann wie gesagt für einen oder beide der ersten metallischen Kontakte 8, 9 durchgeführt werden. Diese Ausführungsform der Erfindung ist von Vorteil, da durch den direkten elektrischen Kontakt der metallischen Kontaktelemente die Leitungswiderstände reduziert werden. Der Begriff einer direkten elektrischen Kontaktierung bedeutet dabei im Sinne der Erfindung, dass der elektrische Kontakt nicht über einen zwischenliegenden Halbleiter erfolgt. Denkbar wäre demgegenüber aber eine weitere, zwischenliegende Metallschicht innerhalb der Bereiche 42, 43.

Ohne Beschränkung auf die speziellen, in den Figuren gezeigten Ausführungsbeispiele ist diese Weiterbildung der Erfindung durch folgende Merkmale gekennzeichnet: zumindest ein Kontaktelement, welches einen ohmschen Kontakt mit der ersten Halbleiterschicht bildet (beispielsweise das erste Kontaktelement 12, welches den Schottky-Kontakt herstellt) und auf welchem die Kunststoffschicht aufgebracht ist, ist mit einem zweiten Kontaktelement in Form einer strukturierten Metallschicht auf der dem Kontaktelement gegenüberliegenden Seite der ersten Halbleiterschicht direkt innerhalb eines Bereiches, in welchem die erste Halbleiterschicht entfernt ist, elektrisch kontaktiert.

Das entsprechende Herstellungsverfahren ist gekennzeichnet durch die Schritte des bereichsweise Entfernens der ersten Halbleiterschicht 4 nach dem Entfernen des Halbleitersubstrats und dem Aufbringen der Kunststoffschicht 23, so dass das erste Kontaktelement 12 oder ein weiteres, durch den metallischen Kontakt 9 gebildetes Kontaktelement, welches einen ohmschen Kontakt mit der ersten Halbleiterschicht 4 bildet, bereichsweise freiliegt und auf welchem die Kunststoffschicht 23 aufgebracht ist, und des Abscheidens einer strukturierten Metallschicht auf der der Kunststoffschicht oder dem ersten oder weiteren Kontaktelement gegenüberliegenden Seite der ersten Halbleiterschicht unter Ausbildung eines zweiten Kontaktelements, welches sich in den Bereich, in welchem das erste oder weitere Kontaktelement (gebildet durch die Kontakte 8, 9) freiliegt, hinein erstreckt, so dass das zweite Kontaktelement einen direkten elektrischen Kontakt mit dem ersten oder weiteren Kontaktelement erhält.

Fig. 14 zeigt eine weitere Variante des erfindungsgemäßen Halbleiter-Bauelements 1. dDiese Variante ist besonders für zur Verarbeitung höchstfrequenter Ströme und Spannungen geeignet. Bei den bisher in den Figuren gezeigten Ausführungsbeispielen ist auf der Mesa-Struktur 19 mit dem Schottky-Kontakt ein ebenso wie das erste Kontaktelement 12 in die Kunststoffschicht 23 eingebettetes weiteres Kontaktelement in Form des Kontaktes 9 vorgesehen, wobei beide Kontaktelemente durch die Strukturierung der Metallschicht 7 erhalten werden. Der elektrische Kontakt 9 stellt ebenso wie das zweite Kontaktelement 14 auf der gegenüberliegenden Seite der ersten Halbleiterschicht 4 einen ohmschen Kontakt zum Halbleiter her.

Dies ist an sich günstig, da hier durch die beidseitige Kontaktierung der ersten Halbleiterschicht 4 eine möglichst große Kontakfläche geschaffen wird, die niedrige Übergangswiderstände mit sich bringt. Andererseits sind für höchste Frequenzen möglichst kleine Halbleiter-Strukturen von Vorteil, um die Kapazitäten der Strukturen klein zu halten.

Bei der in Fig. 14 gezeigten Ausführungsform der Erfindung ist dazu der elektrische Kontakt 9 neben der zweiten Halbleiterschicht der Mesa-Struktur 19, welche den Schottky-Kontakt beinhaltet, weggelassen. Als ohmscher Kontakt dient hier alleine das gegenüber der zweiten Halbleiterschicht 6 auf der ersten Halbleiterschicht 4 angeordnete, durch den zweiten metallischen Kontakt 27 gebildete zweite Kontaktelement 14. Um die Halbleiterstrukturen klein zu halten, ist dies besonders vorteilhaft, da die Fläche, welche der Schottky-Kontakt einnimmt, auf der gegenüberliegenden Seite der ersten Halbleiterschicht 4 nochmals für den ohmschen kontakt des zweiten Kontaktelements ausgenutzt wird. Auch bei den weiter oben beschriebenen Ausführungsbeispielen ist dies im übrigen der Fall, so dass auch bei diesen Ausführungsformen der Erfindung durch die Anordnung des Kontaktelements 14 auf der gegenüberliegenden Seite zusätzliche Kontaktfläche für den ohmschen Kontakt geschaffen wird.

Demgemäß ist in Weiterbildung der Erfindung, ohne Beschränkung auf die in den Figuren dargestellten Ausführungsbeispiele vorgesehen, das zweite Kontaktelement 14 auf der dem in der Kunststoffschicht eingebetteten Schottky-Kontakt 136 gegenüberliegenden Seite der ersten Halbleiterschicht herzustellen, beziehungsweise abzuscheiden. Insbesondere überlappen sich dabei in Aufsicht auf eine Seite des Halbleiter-Bauelements die Flächen des Schottky-Kontakts 136 und des zweiten Kontaktelements 14. Mit anderen Worten sind der Schottky-Kontakt 136 und das zweite Kontaktelement in Richtung auf eine Seite des Halbleiterbauelements übereinander liegend angeordnet. Gemäß dem anhand der Figuren beschriebenen Herstellungsverfahren erfolgt die Herstellung des zweiten Kontaktelements 14 also nach dem Aufbringen der Kunststoffschicht 23 und nach dem Entfernen des Halbleitersubstrat auf der durch das Entfernen des Halbleitersubstrats freigelegten ersten Halbleiterschicht 4.

Gemäß noch einer Weiterbildung der Erfindung, die ebenfalls in Fig. 14 beispielhaft dargestellt ist, wird die erste Halbleiterschicht 4 unter dem ersten metallischen Kontakt 8, beziehungsweise unter dem ersten Kontaktelement 12 bis auf den Bereich unter dem Schottky-Kontakt vollständig entfernt. Dann wird, ähnlich wie bei dem in Fig. 13 gezeigten Ausführungsbeispiel der zweite metallische Kontakt 25 aufgebracht, welcher den ersten metallischen Kontakt 8, beziehungsweise das erste Kontaktelement 12 direkt kontaktiert. Damit werden ohmsche Leitungswiderstände nochmals reduziert.

In Weiterbildung der Erfindung ist daher ohne Beschränkung auf das in Fig. 14 gezeigte Ausführungsbeispiel vorgesehen, dass die erste Halbleiterschicht im Bereich des ersten Kontaktelements 12 bis auf den Schottky-Kontakt 136 auf der dem Mesa 19 vollständig entfernt ist.

Da unter dem ersten Kontaktelement 12 sowohl die erste, als auch die zweite Halbleiterschicht entfernt sind, wird die Schottky-Diode gemäß noch einer Weiterbildung der Erfindung mit einer einzelnen Mesa-Struktur 19 gebildet.

Die Anordnung der Kontaktelemente und Metallschichten ist nicht auf Schottky-Dioden als Halbleiter-Schaltungselemente beschränkt. Selbstverständlich können entsprechende Kontaktelemente auch zur elektrischen Kontaktierung anderer Schaltungselemente, wie Dioden im Allgemeinen, Transistoren, photoempfindliche Halbleiter-Schaltungselemente, Thyristoren, etc. entsprechend ausgebildet werden.

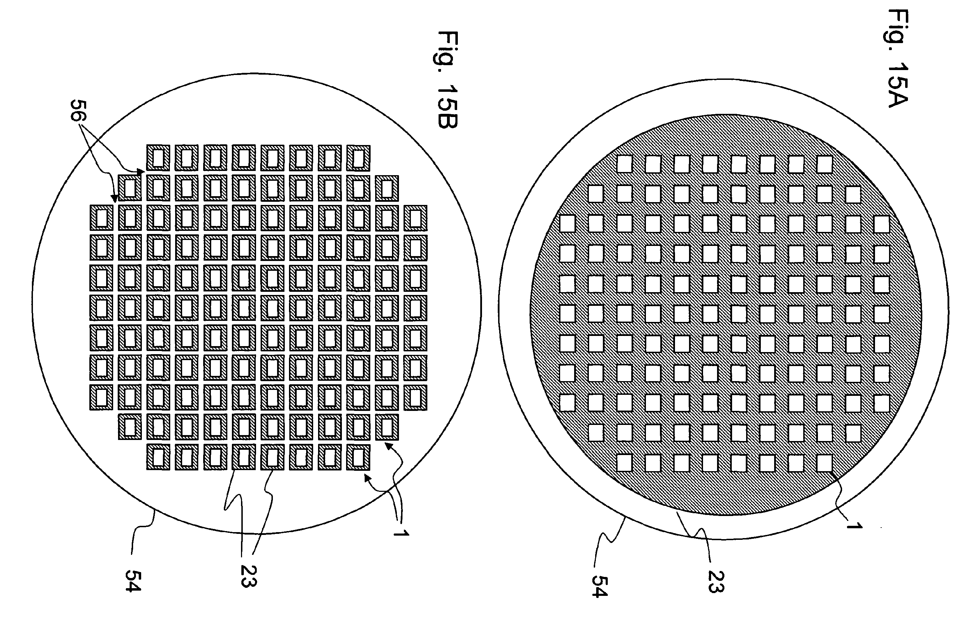

Selbstverständlich ist es günstig, mehrere Schaltungen 1 auf einem Halbleitersubstrat 2, insbesondere in Form eines Wafers zu fertigen. Nachdem das Halbleitersubstrat entfernt ist, wird damit als Zwischenprodukt ein Träger aus einer Kunststoffschicht 23 erhalten, in dem eine Vielzahl von Schaltungen 1 eingebettet ist. Ein solches Zwischenprodukt mit auf einem runden Halbleiterwafer gefertigten Schaltungen, die demgemäß in einer scheibenförmigen Kunststoffschicht 23 mit rundem Umriss eingebettet sind, zeigt schematisch Fig. 15A. Dabei sind die Halbleiterschaltungen 1 nur durch Kästchen symbolisiert.

Die Erfindung bietet hier auch den besonderen Vorteil, dass die einzelnen Schaltungen aus dem Zwischenprodukt sehr leicht heraustrennbar sind, da zum Abtrennen kein Halbleiterwafer mehr zersägt werden muss, sondern nur noch die Kunststoffschicht entlang von vorgesehenen Trennlinien entfernt werden braucht.

Generell bietet sich auch der Vorteil bei der Verwendung von photolithographisch strukturierbaren Kunststoffen für die Kunststoffschicht, dass das Heraustrennen der einzelnen Schaltungen 1 photolithographisch erfolgen kann. Dazu kann der Kunststoffwafer mit den Schaltungen strukturiert belichtet und der Kunststoff in den Trennbereichen entfernt werden. Damit ist die Umrissform des Trägers der einzelnen Schaltung, beziehungsweise des einzelnen Bauelements nicht mehr auf quadratische oder rechteckige Formen beschränkt. Wie weiterhin in Fig. 15A dargestellt, sind die einzelnen Schaltungen 1 hier mit der Kunststoffschicht 23 noch auf dem Trägerteil 54 befestigt. Mit dem Entfernen der Kunststoffschicht zwischen den Halbleiter-Schaltungen 1 und dem Lösen der Verbindung der Kunststoffschicht 23 zum Trägerteil 54 können die Halbleiterschaltungen dann vereinzelt werden.

Gemäß einer weiteren Ausführungsform wird die Kunststoffschicht zwischen den Halbleiter-Schaltungen 1 bereits auf dem Halbleiter-Substrat 2 entfernt. Dann wird das Trägerteil 54 auf der Kunststoffschicht 23 befestigt und das Halbleitersubstrat 2 entfernt. In beiden Fällen ergibt sich damit ein wie in Fig. 15B schematisch dargestelltes Zwischenprodukt, bei dem die Halbleiterschaltungen auf dem Trägerteil 54 fixiert, jedoch jeweils voneinander durch Trennbereiche 56 getrennt sind. Dementsprechend ist auch die hier schraffiert dargestellte Kunststoffschicht 23 in durch die Trennbereiche oder Lücken 56 getrennte Teile aufgeteilt, wobei jedes der Teile eine Halbleiterschaltung 1 trägt.

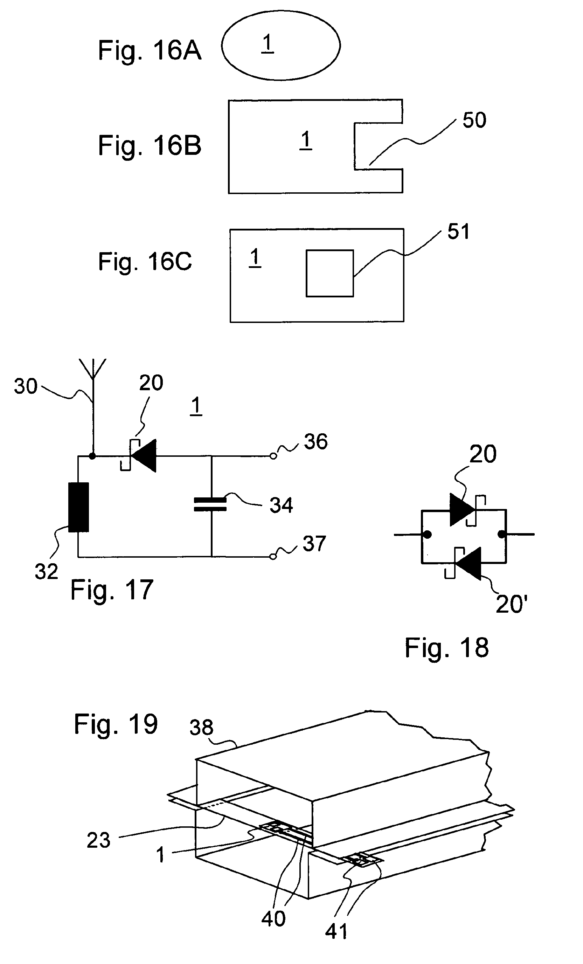

In den Fig. 16A bis 16C sind dazu verschiedene Beispiele von Umrissformen gezeigt. Das oder die Halbleiter-Schaltungselemente, wie insbesondere Schottky-Dioden, sowie die metallischen Kontakte sind der Einfachheit halber nicht dargestellt. Fig. 16A zeigt eine Schaltung 1 mit einem allgemein ovalen Umriss. Als Spezialfall kann die Umrissform damit selbstverständlich auch kreisrund sein. Bei dem in Fig. 16B gezeigten Beispiel weist der Umriss des Trägers einen konkaven Bereich 50 auf. Im Speziellen ist der Bereich 50 ein Einschnitt in einem ansonsten rechteckigen Umriss. Es können ohne weiteres sogar Öffnungen vorgesehen werden. Fig. 16C zeigt dazu ein Beispiel eines Trägers der Schaltung mit einer Öffnung 51.Selbstverständlich können diese vorstehend beschriebenen Merkmale der Umrissform auch miteinander kombiniert werden.

Wie bereits oben beschrieben, eignet sich die Erfindung besonders als Detektor für hochfrequente elektromagnetische Felder.

Ein Beispiel für ein integriertes Halbleiterbauelement in Form einer Detektorschaltung, die vollständig mit den Herstellungsschritten gemäß den Fig. 1 bis 8 realisierbar ist, zeigt Fig. 17. Die Schaltung 1 umfasst eine Antenne 30 und einen auf die zu erfassende Frequenz abgestimmten Schwingkreis mit einer Induktivität 32 und einer Kapazität 34. In den Schwingkreis ist die Schottky-Diode 20 geschaltet.

Zwischen den Ausgängen 36, 37 kann dann das von der Schottky-Diode 20 amplitudendemodulierte Signal abgegriffen werden. Die Antenne 30, die Induktivität 32 und die Kapazität 34 können durch geeignete leitende Strukturen der Metallschicht 7 und/oder der Metallschicht der zweiten metallischen Kontakte 25, 27 aufgebaut werden. Wird die Schottky-Diode als Zero-Bias-Diode ausgelegt, ist auch keine Bias-Spannung notwendig, um die Signale zu demodulieren.

Fig. 18 zeigt eine weitere Schaltung, die als Bestandteil eines Verdopplers oder subharmonischen Mischer verwendet werden kann. Die Schaltung umfasst die beiden in einer Schleife geschalteten Schottky-Dioden 20, 20'. Mit einer solchen Anordnung in Verbindung mit der erfindungsgemäßen Bauweise des integrierten Bauelelements lassen sich dann in einfacher Weise elektromagnetische Felder mit extrem hohen, bisher kaum zu erreichenden Frequenzbereichen weit oberhalb von 10 GHz erzeugen.

Fig. 19 zeigt eine beispielhafte Anwendung einer Detektorschaltung, wie sie in Fig. 17 gezeigt ist. In einem Hohlleiter 38 ist der Träger in Form der Kunststoffschicht 23 mit der darin eingebetteten Schaltung 1 eingesetzt. Das von der Schaltung 1 im Inneren des Hohlleiters 38 detektierte und demodulierte Signal wird über Leiterbahnen 40 entlang der Kunststoffschicht 23 zu Anschlussflächen 41 außerhalb des Hohlleiters 38 geleitet und kann dort abgegriffen werden.

Alternativ kann die Schaltung mit der Kunststoffschicht 23 auch auf einem weiteren Kunststoffträger mit Leiterbahnen 40 aufgesetzt und an die Leiterbahnen 40 angeschlossen werden. In beiden Fällen sind außer den elektronischen Komponenten und den Leitern keine metallischen oder halbleitenden Elemente am erfindungsgemäßen Detektor im Inneren des Hohlleiters vorhanden. Dies bietet den großen Vorteil, dass Störungen der Wellenleitung im Hohlleiter durch die Detektorschaltung auf ein Minimum reduziert werden.

Bei den anhand der Fig. 9 bis 14 dargestellten Ausführungsformen der Erfindung wurden die elektrischen Anschlusskontakte für die Halbleiter-Schaltung durch die zweiten metallischen Kontakte bereitgestellt, die auf der Seite der Schaltung, auf der das Halbleiter-Substrat angeordnet war, beziehungsweise auf der Seite der Schaltung, welche der Kunststoffschicht 23 gegenüberliegt angeordnet sind.

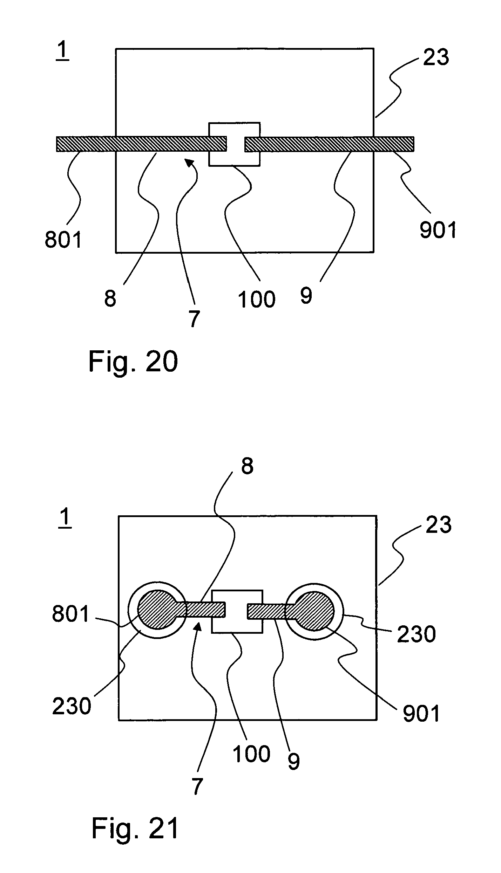

Es ist aber auch möglich, eine elektrische Kontaktierung durch einen oder mehrere Anschlusskontakte herzustellen, die aus der ersten metallischen Schicht 7 ausgebildet werden. Demgemäß ist gemäß einer weiteren Ausführungsform der Erfindung vorgesehen, dass die Halbleiter-Schaltung eine metallische Schicht 7 umfasst, welche zumindest ein erstes Kontaktelement für ein Halbleiter-Schaltungselement bildet und auf welche die Kunststoffschicht 23 aufgebracht ist, wobei aus der metallischen Schicht 7 ein elektrischer Anschlusskontakt ausgebildet ist, welcher am Rand der Kunststoffschicht 23 oder in einer Öffnung in der Kunststoffschicht 23 zur Herstellung einer elektrischen Kontaktierung freigelegt ist. Das Freilegen der elektrischen Anschlußelemente ist besonders einfach möglich, indem die Kunststoffschicht 23 photolithographisch strukturiert wird. Dazu zeigen Fig. 20 und 21 zwei Ausführungsbeispiele.

In den Fig. 20 und 21 ist die Halbleiter-Schaltung 1 in Aufsicht auf die Kunststoffschicht 23 dargestellt. Das Halbleiter-Schaltungselement 100, beispielsweise wieder eine Schottky-Diode, oder auch ein anderes Halbleiterelement mit mehreren funktionellen, epitaktischen Halbleiterschichten ist nur schematisch dargestellt.

Wie bei den vorhergehend beschriebenen Ausführungsbeispielen ist die metallische Schicht 7 unter Ausbildung zweier metallischer Kontakte 8, 9 strukturiert, welche die Halbleiterschichten des Halbleiter-Schaltungselements 100 kontaktieren. Die in die Kunststoffschicht eingebetteten metallischen Kontakte 8, 9 ragen über den Rand der Kunststoffschicht 23 hinaus. Diese herausragenden Enden bilden nun elektrische Anschlusskontakte 801, 901, an welchen Signale und/oder Versorgungsspannungen abgegriffen oder zugeführt werden können. Eine derartige Anordnung ist sehr einfach durch eine wie oben beschriebene photolithographische Auftrennung der Kunststoffschicht 23 zu erreichen. Verlaufen die Anschlusskontakte 801, 802 im Trennbereich zwischen den einzelnen Schaltungen 1, so werden diese Anschlusskontakte beim Entfernen des Kunststoffs freigelegt.

Fig. 21 zeigt hierzu eine Variante. Hier sind die Anschlusskontakte 801, 802 nicht über den Rand hinaus geführt. Vielmehr liegen die Anschlusskontakte 801, 802 innerhalb der Umrandung des durch die Kunststoffschicht 23 geschaffenen Kunststoffträgers. Um die Anschlusskontakte kontaktieren zu können, sind in die Kunststoffschicht 23 Öffnungen 230 an den Stellen der Anschlusskontakte 801, 801 eingefügt.

Auch diese Öffnungen 230 lassen sich photolithographisch erzeugen. Ein zusätzlicher Prozessschritt ist dazu nicht notwendig, da das Einfügen der Öffnungen gleichzeitig mit dem photolithographischen Auftrennen der Schaltungen 1 erfolgen kann. Selbstverständlich können die Anschlusskontakte gemäß den Fig. 20 und 21 miteinander, sowie auch mit Anschusskontakten durch einen oder mehrere zweite metallische Kontakte 25, 27, wie sie in den Fig. 9 bis 14 dargestellt sind, kombiniert werden.

## Patentansprüche

1. Verfahren zur Herstellung von Halbleiter-Schaltungen (1), bei welchem
- ein Halbleitersubstrat (2) mit mindestens zwei darauf abgeschiedenen, epitaktischen Halbleiterschichten (4, 6) verwendet wird, und wobei aus den Halbleiterschichten (4, 6) zumindest ein Halbleiter-Schaltungselement hergestellt wird, und wobei dann
- eine Kunststoffschicht (23) auf das Halbleitersubstrat (2) auf die Seite mit den Halbleiterschichten (4, 6) aufgebracht wird, welche das Halbleiter-Schaltungselement abdeckt, und wobei
- dann das Halbleiter-Substrat (2) entfernt wird, wobei nach Entfernung des Halbleiter-Substrats (2) die Kunststoffschicht (23) einen freitragenden Träger für das Halbleiter-Schaltungselement bildet.

2. Verfahren gemäß dem vorstehenden Anspruch, zur Herstellung von Halbleiter-Schaltungen mit zumindest einer Schottky-Diode (20), bei welchem
- aus den Halbleiterschichten eine Mesa-Struktur erzeugt, und
- eine metallische Schicht (7) aufgebracht wirddie unter Ausbildung eines ersten Kontaktelements (12) strukturiert wird, welche die Mesa-Struktur unter Bildung eines Schottky-Kontakts (136) kontaktiert, und wobei
- die Kunststoffschicht (23) auf das Halbleitersubstrat (2) aufgebracht wird, so daß sie die Mesa-Struktur (19) und den Schottky-Kontakt (136) einbettet.

3. Verfahren gemäß Anspruch 2, wobei ein zweites Kontaktelement (14) nach dem Aufbringen der Kunststoffschicht (23) und nach dem Entfernen des Halbleitersubstrats (2) auf der durch das Entfernen des Halbleitersubstrats (2) freigelegten ersten Halbleiterschicht (4) abgeschieden wird, wobei sich in Aufsicht auf eine Seite des Halbleiter-Bauelements die Flächen des Schottky-Kontakts (136) und des zweiten Kontaktelements (14) überlappen.

4. Verfahren nach einem der vorstehenden Ansprüche, wobei nach dem Aufbringen der Kunststoffschicht (23) und dem Entfernen des Halbleitersubstrats (2) zweite metallische Kontakte (25, 27) durch Abscheiden und Strukturieren einer ein- oder mehrlagigen Metallschicht auf der durch Entfernen des Halbleitersubstrats (2) freigelegten Seite des Halbleiter-Bauelements hergestellt werden.

5. Verfahren nach vorstehendem Anspruch, wobei einer der zweiten metallischen Kontakte auf der Mesa-Struktur aufgebracht ist und einen ohmschen Kontakt zu einer der Halbleiterschichten (4, 6) herstellt.

6. Verfahren gemäß einem der beiden vorstehenden Ansprüche, **dadurch gekennzeichnet, dass** zumindest einer der zweiten metallischen Kontakte (25, 27) auf einem ersten metallischen Kontakt (8, 9), auf welchem die Kunststoffschicht (23) aufgebracht ist, abgeschieden wird und damit den ersten metallischen Kontakt (8, 9) direkt elektrisch kontaktiert.

7. Verfahren nach einem der vorstehenden Ansprüche, **dadurch gekennzeichnet, dass** die Kunststoffschicht (23) mit einer Dicke im Bereich bis 20 Mikrometern aufgebracht wird.

8. Verfahren gemäß einem der vorstehenden Ansprüche, **dadurch gekennzeichnet, dass** die Halbleiter-Schaltung mit der Kunststoffschicht (23) auf einem Trägerteil (54) befestigt und anschließend das Halbleitersubstrat (2) entfernt wird, wobei nach dem Entfernen des Halbleitersubstrats (2) und gegebenenfalls weiterer Verfahrensschritte, insbesondere dem Aufbringen zweiter metallischer Kontakte (25, 27) gemäß Anspruch 4 das Trägerteil (54) entfernt wird, so dass die Kunststoffschicht (23) nach dem Entfernen des Trägerteils (54) den freitragenden Träger für das Halbleiter-Schaltungselement bildet.

9. Verfahren gemäß dem vorstehenden Anspruch, **dadurch gekennzeichnet, dass** aus den Halbleiterschichten (4, 6) mehrere Halbleiter-Schaltungen (1) hergestellt werden, wobei die Kunststoffschicht (23) vor dem Befestigen auf dem Trägerteil (54) oder während die Kunststoffschicht auf dem Trägerteil (54) befestigt ist, aufgetrennt wird, so dass nach dem Entfernen des Trägerteils (54) vereinzelte Halbleiter-Schaltungen erhalten werden.

10. Verfahren gemäß einem der vorstehenden Ansprüche, wobei aus den Halbleiterschichten (4, 6) mehrere Halbleiter-Schaltungen (1) hergestellt werden, und wobei die Kunststoffschicht (23) zwischen den Halbleiter-Schaltungen (1) photolithographisch entfernt wird.

11. Halbleiter-Schaltung, insbesondere herstellbar mit einem Verfahren gemäß einem der vorstehenden Ansprüche, mit zumindest einem Halbleiter-Schaltungselement, wobei das Halbleiter-Schaltungselement
- funktionelle epitaktische Halbleiterschichten (4, 6) umfasst, und wobei die Halbleiter-Schaltung
- eine Kunststoffschicht (23) umfasst, welche das Halbleiter-Schaltungselement abdeckt und einbettet und einen freitragenden Träger für das Halbleiter-Schaltungselement bildet.

12. Halbleiter-Schaltung gemäß dem vorstehenden Anspruch, mit zumindest einer Schottky-Diode (20), wobei die Halbleiter-Schaltung
- eine Mesa-Struktur (19), sowie
- eine metallische Schicht (7) umfasst, welche so strukturiert ist, dass sie ein erstes Kontaktelement bildet, welche die Mesa-Struktur (19) unter Bildung eines Schottky-Kontakts (136) kontaktiert, und wobei
- die Kunststoffschicht (23) das erste Kontaktelement abdeckt und den Schottky-Kontakt (136) einbettet.

13. Halbleiter-Schaltung gemäß vorstehendem Anspruch, wobei ein zweites Kontaktelement (14) auf der dem in der Kunststoffschicht (23) eingebetteten Schottky-Kontakt (136) gegenüberliegenden Seite der ersten Halbleiterschicht (4) angeordnet ist, wobei sich in Aufsicht auf eine Seite des Halbleiter-Bauelements die Flächen des Schottky-Kontakts (136) und des zweiten Kontaktelements (14) überlappen.

14. Halbleiter-Schaltung gemäß einem der vorstehenden Ansprüche, wobei zumindest ein metallischer Kontakt (8, 9) für die Halbleiterschichten (4,6), auf welchem die Kunststoffschicht (23) aufgebracht ist, mit einem zweiten metallischen Kontakt 25, 27 auf der gegenüberliegenden Seite der Halbleiterschichten (4, 6) direkt elektrisch kontaktiert.

15. Halbleiter-Schaltung gemäß einem der vorstehenden Ansprüche, **dadurch gekennzeichnet, dass** die Halbleiter-Schaltung eine metallische Schicht (7) umfasst, welche zumindest ein erstes Kontaktelement für ein Halbleiter-Schaltungselement bildet und auf welche die Kunststoffschicht aufgebracht ist, und wobei aus der metallischen Schicht (7) ein elektrischer Anschlusskontakt ausgebildet ist, welcher am Rand der Kunststoffschicht (23) oder in einer Öffnung in der Kunststoffschicht (23) zur Herstellung einer elektrischen Kontaktierung freigelegt ist.

16. Verwendung eines Halbleiter-Bauelements gemäß einem der vorstehenden Ansprüche zur Erzeugung, Detektion und Bearbeitung hochfrequenter elektromagnetischer Felder.
